Europäisches Patentamt

**European Patent Office**

Office européen des brevets

(19)

(11) Veröffentlichungsnummer: **0 053 602**
**B1**

(12) # EUROPÄISCHE PATENTSCHRIFT

(45) Veröffentlichungstag der Patentschrift:
**10.07.85**

(51) Int. Cl.⁴: **H 03 K 5/08,** G 01 R 29/027,
F 02 P 17/00

(21) Anmeldenummer: **81890187.8**

(22) Anmeldetag: **10.11.81**

(54) **Einrichtung zur Erzeugung eines Impulses.**

(30) Priorität: **28.11.80 AT 5836/80**

(43) Veröffentlichungstag der Anmeldung:
**09.06.82 Patentblatt 82/23**

(45) Bekanntmachung des Hinweises auf die Patenterteilung:
**10.07.85 Patentblatt 85/28**

(84) Benannte Vertragsstaaten:
**CH DE FR GB IT LI**

(56) Entgegenhaltungen:
**DE - A - 2 347 800**
**DE - A - 3 001 908**
**DE - B - 2 815 524**

(73) Patentinhaber: **List, Hans, Heinrichstrasse 126,
A-8010 Graz (AT)**

(72) Erfinder: **Denk, Heimo, Färbergasse 5, A-8330 Feldbach
(AT)**
Erfinder: **Mantsch, Peter, Stiftingtalstrasse 223a,
A-8010 Graz (AT)**
Erfinder: **Moser, Werner, Papiermühlgasse 28,
A-8020 Graz (AT)**

(74) Vertreter: **Krause, Walter, Dr. Dipl.-Ing.,
Margaretenstrasse 21, A-1040 Wien (AT)**

## Beschreibung

Die Erfindung betrifft eine Einrichtung zur Erzeugung eines mit dem zeitlichen Auftreten eines zumindest annähernd periodischen Ereignisses korrespondierenden elektrischen Impulses, mit zumindest einem auf das Auftreten des Ereignisses ansprechenden Sensor, der eine elektrische Signalfolge an eine Auswerteeinheit abgibt, welche eine Erkennungsschaltung umfaßt, die nach Eintreffen der Signale ein von Störungen unbeeinflußtes stabiles Erkennungssignal abgibt, in Abhängigkeit von dessen Auftreten die Aktivierung einer Torschaltung erfolgt, an deren Ausgang der dem Auftreten des periodischen Ereignisses zuordenbare Impuls abnehmbar ist.

Derartige Einrichtungen haben die Aufgabe, die vom Sensor beim Auftreten des Ereignisses abgegebene elektrische Signalfolge, welche eine von der Art des Ereignisses sowie von verschiedenen äußeren Einflüssen auf die gesamte Meßanordnung abhängige zeitliche Amplitudenverteilung aufweist, so auszuwerten, daß aus der Signalfolge ein mit dem zeitlichen Auftreten des Ereignisses korrespondierender Triggerpunkt bestimmt werden kann, der für die weitere Auswertung dem Zeitpunkt des Auftretens des Ereignisses zugeordnet ist.

Die beispielsweise von der Bestimmung des Einspritzzeitpunktes bei Verbrennungskraftmaschinen bekannten derartigen Einrichtungen verwenden als Erkennungsschaltung im wesentlichen einen Komparator in der Auswerteeinheit, an dessen einem Eingang das über den Sensor gelieferte Signal und an dessen anderem Eingang ein Referenzsignal von bekannter Höhe liegt und der somit bei überschreitung des Refenrenzsignals durch das Sensorsignal ein die Erreichung des gewünschten Triggerpegels anzeigendes Ausgangssignal zur Weiterverwendung abgibt. Da neben dem eigentlichen, das Auftreten des nachzuweisenden Ereignisses anzeigenden Signal in der vom Sensor abgegebenen Signalfolge auch Störungen enthalten sind, welche sich aus echten, unabhängig vom nachzuweisenden Ereignis auftretenden Störsignalen und aus solchen, die zwar auch vom zu messenden Effekt verursacht werden, jedoch mit dem Ereignis selbst nicht unmittelbar zu tun haben, zusammensetzen, wird die Schaltschwelle des für die Erkennung des Auftretens des Ereignisses dienenden Komparators üblicherweise so gewählt, daß sie von den Signalen der genannten Störungen nicht erreicht wird. Damit ist es aber auch unmöglich, den genannten Triggerpunkt wirklich an den Beginn des nachzuweisenden Ereignisses, also an den Fußpunkt des über den Sensor erhaltenen Signalanstieges zu legen, weil die Störungen von der Auswerteeinheit, bzw. von der Erkennungsschaltung nicht als solche identifiziert werden können. Da die genannten Störungen aber sogar höhere Signale als das eigentlich auszuwertende liefern können, sind die bekannten Einrichtungen mit zufriedenstellendem Ergebnis nur bei praktisch störungsfreien Meßsignalen verwendbar, da nur bei derartigen Signalfolgen die Schaltschwelle der Erkennungsschaltung relativ frei wählbar ist.

Aus der DE-OS 2 347 800 ist eine Einrichtung zur Erzeugung eines, einem periodischen Ereignis entsprechenden elektrischen Signals bekannt, bei welcher Einrichtung einerseits ein von dem von einem Sensor abgefühlten Signal abgeleitetes Signal bei überschreitung eines bestimmten Signalpegels einer Torschaltung zugeführt wird und diese aktiviert, und andererseits ein einem speziellen Charakteristikum des vom Sensor abgefühlten Signals, nämlich des in der Signalmitte liegenden Nulldurchgangs, entsprechendes Signal ebenfalls der Torschaltung zugeführt wird, welche nach ihrer Aktivierung das dem Nulldurchgang entsprechende Signal an ihrem Ausgang zur Verfügung stellt. Eine genaue Bestimmung des tatsächlichen Beginnes des periodischen Ereignisses bzw. des sinusförmigen Signals kann mit dieser Einrichtung jedoch nicht erfolgen, da Störungen zu Signalbeginn nicht ausgeschaltet werden können, und die Anordnung eine zu große Zeitverzögerung besitzt.

Aufgabe der vorliegenden Erfindung ist es, eine Einrichtung der eingangs genannten Art so zu verbessern, daß die angeführten Nachteile vermieden werden und daß es insbesonders möglich ist, auch bei mit starken Störsignalen behafteten Sensorsignalen den Beginn des nachzuweisenden Ereignisses zu bestimmen.

Dies wird gemäß der Erfindung dadurch ermöglicht, daß die Auswerteeinheit zusätzlich eine Unterteilungsschaltung und eine Komparatorschaltung umfaßt, wobei die der Erkennungsschaltung nachgeschaltete Unterteilungsschaltung den zeitlichen Abstand zwischen dem Auftreten von zwei Erkennungssignalen in Teilbereiche zerlegt und die an die Unterteilungsschaltung angeschlossene Torschaltung in einem vorbestimmten derartigen Teilbereich aktiviert, und daß die Signalfolge des Sensors der Komparatorschaltung zugeführt ist, welche bei überschreitung eines vorbestimmten Signalpegels einen elektrischen Impuls an die Torschaltung abgibt, über die dieser in ihrem aktivierten Zustand der weiteren Vervendung zuführbar ist. Dabei wird die Tatsache genutzt, daß bei den meisten derartigen Meßaufgaben die Amplituden der Störsignale in einem kleinen zeitlichen Bereich vor dem Beginn des eigentlich nachzuweisenden periodischen Ereignisses sehr klein sind, so daß in diesem Bereich eine Komparatorschaltung mit einem Spannungskomparator verwendet werden kann, dessen Ansprechpegel genügend niedrig liegt, so daß der erzeugte Triggerimpuls auf alle Fälle noch im Anfangsteil des nachzuweisenden, annähernd periodischen Ereignisses zu liegen kommt. Um dabei sicherzustellen, daß Störsignale, die zeitlich außerhalb dieses unmittelbar um das Auftreten des nachzuweisenden Ereignisses liegenden Bereiches gegebenenfalls auftreten, zu keiner Triggerimpulserzeugung führen, wird durch die Torschaltung ein sehr kleines sogenanntes Fenster um den Zeitpunkt des erwarteten Auftretens der Ereignisses erzeugt, innerhalb dessen die von der zusätzlichen Komparatorschaltung gegebenenfalls gelieferten Schaltimpulse akzeptiert und außerhalb dessen diese Impulse unterdrückt werden. Zur Erzeugung dieses Fensters wird die Torschaltung dabei von einer Unterteilungsschaltung aktiviert, welche den zeitlichen Abstand zwischen dem Auftreten von zwei aufeinanderfolgenden periodischen Ereignissen in Teilbereiche zerlegt. Dieser zeitliche Abstand wird dabei aus Erkennungssignalen gewonnen, welche über eine Erkennungsschaltung geliefert werden, die beispielsweise nach dem eingangs angeführten bekannten Prinzip funktioniert und einen Schaltpegel aufweist, der über dem Signalpegel der vorkommenden Störsignale liegt. Der zeitliche Teilbereich, in welchem die Torschaltung aktiviert ist, wird dabei so gelegt, daß der — in groben Grenzen natürlich bekannte — Beginn des zumindest annähernd periodischen Ereignisses zeitlich innerhalb dieses Bereiches zu liegen kommt. Die von der die Unterteilungsschaltung steuernden Erkennungsschaltung unabhängige, zusätzliche Komparatorschaltung kann dabei auf eine Schaltschwelle eingestellt sein, welche gerade über der Pegelhöhe der unter Umständen auch in diesem Bereich noch auftretenden, jedoch hier nur eine sehr geringe Signalhöhe aufweisenden Störungen liegt, womit die Abweichung des schließlich dem Beginn des nachzuweisenden periodischen Ereignisses zugeordneten Impulses vom tatsächlichen Beginn vernachlässigbar klein gehalten werden kann.

Um auch bei etwas größeren Abweichungen in der Periodizität des nachzuweisenden Ereignisses einen dem Beginn des Ereignisses zuordenbaren Impuls erzeugen zu können, ist in Weiterbildung der Erfindung vorgesehen, daß die Torschaltung in zumindest einem zweiten, gegenüber dem ersten längeren, Teilbereich zwischen dem Auftreten zweier Erkennungssignale zusätzlich aktiviert ist, wobei zwischen Sensor und Komparatorschaltung ein elektronisches Filter mit veränderbarer Zeitkonstante eingeschaltet ist, welches im Teilbereich der zusätzlichen Aktivierung der Torschaltung eine gegenüber dem ersten, kürzeren Teilbereich erhöhte Zeitkonstante aufweist. Es ist also neben dem ersten durch die Torschaltung erzeugten relativ schmalen Fenster zumindest ein weiteres, zeitlich breiteres Fenster vorgesehen, wobei die Gefahr, daß während der verlängerten Aktivierungszeit der Torschaltung durch Störsignale erzeugte Triggerimpulse dem Beginn des periodischen Ereignisses zugeordnet werden, durch das eingeschaltete elektronische Filter beseitigt ist. Dieses Filter mit größerer Zeitkonstante hat zur Folge, daß die auf Störungen zurückzuführenden Signale innerhalb des erweiterten Fensters so klein bleiben, daß die Schaltschwelle der Komparatorschaltung nicht überschritten und somit kein Triggerimpuls erzeugt wird.

Da die Unterdrückung der Störsignale im Bereich des erweiterten Fensters über die Zeitkonstante des Filters natürlich weiterhin auch zur Folge hat, daß der durch das Auftreten des Ereignisses schließlich erzeugte Triggerimpuls mit einer Zeitverzögerung behaftet ist, ist gemäß einer besonders vorteilhaften Ausgestaltung der Erfindung vorgesehen, daß die Zeitkonstante des elektronischen Filters zumindest im zusätzlichen, längeren Teilbereich in Abhängigkeit von der Auftrittsfrequenz des periodischen Ereignisses veränderbar ist. Damit wird der aufgrund der Zeitverzögerung durch das Filter auftretende Zeitfehler optimal klein gehalten.

Bei nicht sehr stark von der Periodizität abweichenden Ereignissen reicht es jedoch auf alle Fälle aus, nur mit einem einzigen durch die Torschaltung definierten Fenster zu arbeiten, wobei jedoch auch in diesem Falle ein von der Auftrittsfrequenz des Ereignisses beeinflußtes Filter für die an die Komparatorschaltung gelieferten Signale vorgesehen sein kann, dessen frequenzabhängige Zeitkonstante jedoch vorteilhafterweise so klein ist, daß der Echtzeitfehler des erzeugten Triggersignales praktisch vernachlässigbar ist.

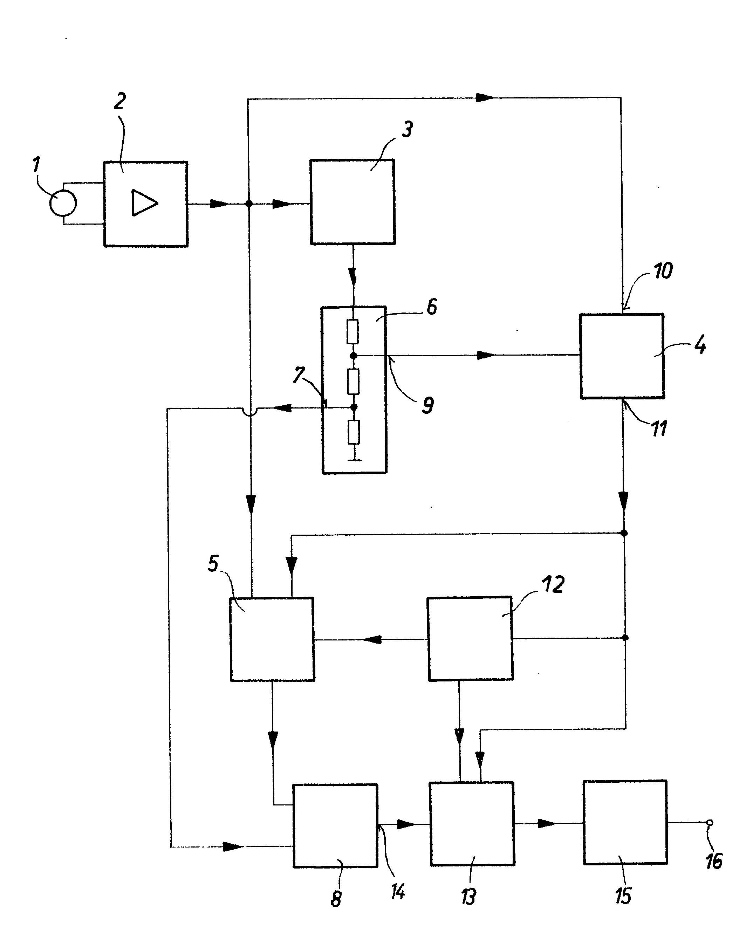

Die Erfindung wird im folgenden anhand eines in der Zeichnung schematisch dargestellten Blockschaltbildes näher erläutert.

Ein auf das Auftreten eines zumindest annähernd periodischen und hier nicht näher spezifizierten Ereignisses ansprechender Sensor 1 ist über eine Signalaufbereitungsschaltung 2, welche einen Verstärker und gegebenenfalls elektronische Filter umfaßt, mit einem Spitzenwertspeicher 3, einer Erkennungsschaltung 4 und einem elektronischen Filter 5 verbunden. Der Ausgang des Spitzenwertspeichers 3 ist einem Spannungsteiler 6 zugeführt, der an einem Ausgang 7 eine Referenzspannung für eine Komparatorschaltung 8 und an einem weiteren Ausgang 9 eine Referenzsspannung für die Erkennungsschaltung 4 abgibt. Im dargestellten Ausführungsbeispiel weisen die an den Ausgängen 7 und 9 des Spannungsteilers 6 liegenden Referenzspannungen stets ein vorbestimmtes, gleichbleibendes Prozentualverhältnis zur über den Spitzenwertspeicher 3 gelieferten maximalen Signalspannung des Sensors 1 auf; der Ausgang 7 weist beispielsweise 10% des Spitzenwertes des gelieferten Sensorsignals und der Ausgang 9 beispielsweise 50% des Spitzenwertes auf.

Die Erkennungsschaltung 4 ist nun so aufgebaut, daß bei Überschreiten des über den Ausgang 9 des Spannungsteilers 6 gelieferten Referenzspannungswertes durch das am Eingang 10 liegende Sensorsignal am Ausgang 11 ein Triggerimpuls abgegeben wird, der dem zeitlichen Auftreten des über den Sensor 1 nachzuweisenden Ereignisses zuordenbar ist. Dies kann im Prinzip bereits durch einen einfachen Spannungskomparator erreicht werden, ist jedoch beispielsweise auch durch eine Schaltung nach Art der in der DE-AS 2 815 524 geoffenbarten Einrichtung, welche bereits in der vom Sensor gelieferten Signalfolge enthaltene Störungen berücksichtigt, realisierbar.

Das am Ausgang 11 der Erkennungsschaltung 4 erhaltene Signal korreliert zwar aufgrund des die Störungen in der Signalfolge unterdrückenden relativ hohen Referenzspannungspegels direkt mit dem Auftreten des nachzuweisenden Ereignisses, jedoch tritt eben aufgrund des relativ hohen Ansprechpegels der gravierende Nachteil auf, daß nicht der Beginn des nachzuweisenden Ereignisses zum Auslösen eines entsprechenden Triggerimpulses führt, sondern daß dieser kennzeichnende Impuls erst relativ spät, nämlich nachdem aufgrund der bereits relativ hohen Signalpegelhöhe Störungen ausgeschlossen werden können, abgegeben wird. Die am Ausgang 11 der Erkennungsschaltung 4 mit dem Auftreten des nachzuweisenden Ereignisses periodisch abgegebenen Erkennungssignale werden einer Unterteilungsschaltung 12 zugeführt, und von dieser dazu verwendet, die Periodenzeit der Erkennungssignale in vorbestimmte Abschnitte zu unterteilen. Diese Unterteilung der Erkennungssignalperiode kann beispielsweise mit Hilfe eines Phasenregelkreises oder mit Hilfe von anderen bekannten Methoden der Analog- oder Digitaltechnik durchgeführt werden, wobei die Anzahl der Unterteilungsschritte praktisch frei wählbar ist. Bewährt haben sich Unterteilungsschaltungen, welche beispielsweise für im Zusammenhang mit Drehbewegungen auftretenden periodischen Ereignissen den zeitlichen Abstand zwischen dem Auftreten von aufeinanderfolgenden derartigen Ereignissen in 360 Teile oder ein ganzzahliges Vielfaches davon aufteilen, da damit unmittelbar Winkelaussagen über das Eintreten des Ereignisses gemacht werden können Im Zusammenhang mit andersartigen nachzuweisenden Ereignissen kann sich jedoch auch jede beliebige andere Unterteilung als vorteilhaft erweisen.

Diese Unterteilung der Periodenzeit zwischen dem Auftreten der stabilen Erkennungssignale erfolgt zu dem Zweck, das Öffnungsfenster bzw. die Aktivierungszeit für eine Torschaltung 13 zu definieren, welcher die von der Komparatorschaltung 8 gelieferten Impulse zugeführt sind. Die Komparatorschaltung 8 wird dabei — wie erwähnt — über den Spannungsteiler 6 mit einer Referenzspannung versorgt, welche beispielsweise 10% der über den Spitzenwertspeicher 3 gelieferten maximalen Signalspannung beträgt. Andererseits liegt — unter Zwischenschaltung des Filters 5 — an der Komparatorschaltung 8 unmittelbar die von der Signalaufbereitungsschaltung 2 gelieferte Signalfolge des Sensors 1. Bei Überschreitung ihrer Referenzspannung durch das Sensorsignal wird also die Komparatorschaltung 8 über ihren Ausgang 14 einen Impuls abgeben, der jedoch nur bei in vorher beschriebener Weise aktivierter Torschaltung 13 diese passiert und beispielsweise über einen nachgeschalteten Impulsformer 15 am Ausgang 16 der gesamten Einrichtung abgreifbar ist.

Um auch bei größeren Unregelmäßigkeiten in der Periodizität des über den Sensor 1 nachzuweisenden Ereignisses mit dem über die Komparatorschaltung 8 erhaltenen, dem Beginn des Ereignisses zuordenbaren Impuls nicht außerhalb des durch die Torschaltung 13 definierten Fenster zu fallen, ist im dargestellten Ausführungsbeispiel die Unterteilungsschaltung 12 so ausgebildet, daß auch ein zweites, zeitlich längeres Fenster für die Öffnung der Torschaltung 13 erzeugt wird. Um in diesem Zusammenhang zu vermeiden, daß auch vor dem Beginn des eigentlich nachzuweisenden Ereignisses auftretende Störungen mit relativ hohem Signalpegel zur Abgabe eines die aktivierte Torschaltung passierenden Impulses der Komparatorschaltung 8 führen, ist das stabile Erkennungssignal vom Ausgang 11 der Erkennungsschaltung 4 auch dem elektronischen Filter 5 zugeführt, und wird dort dazu verwendet, um mit bekannten Methoden die Filterzeitkonstante in Abhängigkeit von der Auftrittsfrequenz des Erkennungssignales zu ändern. Das Filter 5 wird weiters von der Unterteilungsschaltung 12 dahingehend beeinflußt, daß für die über die Unterteilungsschaltung 12 definierten verschiedenen Teilbereiche der Zeit zwischen dem Auftreten der nachzuweisenden Ereignisse verschiedene Zeitkonstanten vorgesehen werden, wobei insbesondere die Zeitkonstante während des verlängerten Zeitbereiches so weit vergrößert ist, daß in diesem Bereich unter Umständen auftretende Störsignale so weit unterdrückt werden, daß es zu keiner Auslösung der Komparatorschaltung 8 kommt. Dies erlaubt zwar die Gewinnung eines entsprechenden Triggerimpulses auch bei stärkeren Schwankungen in der Periodizität des nachzuweisenden Ereignisses, jedoch ist durch die erhöhte Zeitkonstante des Filters 5 auch ein kleiner Zeitfehler nicht auszuschließen. Um diesen Fehler optimal klein zu halten, ist es nun besonders vorteilhaft, die Zeitkonstante des Filters in Abhängigkeit von der Auftrittsfrequenz des nachzuweisenden Ereignisses zu verändern.

Die Torschaltung 13 ist außerdem von der Erkennungsschaltung 4 so beeinflußt, daß mit dem Auftreten des Erkennungssignales der Impulsdurchgang bis zum Beginn des nächsten, von der Unterteilungsschaltung 12 erzeugten Freigabefensters gesperrt wird. Über den Impulsformer 15 schließlich wird der von der Komparatorschaltung 8 abgegebene Impuls in eine für die folgende Weiterverarbeitung geeignete Form gebracht.

## Patentansprüche

1. Einrichtung zur Erzeugung eines mit dem zeitlichen Auftreten eines zumindest annähernd periodischen Ereignisses korrespondierenden elektrischen Impulses, mit zumindest einem auf das Auftreten des Ereignisses ansprechenden Sensor (1), der eine elektrische Signalfolge an eine Auswerteeinheit abgibt, welche eine Erkennungsschaltung (4) umfaßt, die nach Eintreffen der Signalfolge ein von Störungen unbeeinflußtes stabiles Erkennungssignal abgibt, in Abhängigkeit von dessen Auftreten die Aktivierung einer Torschaltung (13) erfolgt, an deren Ausgang der dem Auftreten des periodischen Ereignisses zuordenbare Impuls abnehmbar ist, dadurch gekennzeichnet, daß die Auswerteeinheit zusätzlich eine Unterteilungsschaltung (12) und eine Komparatorschaltung (8) umfaßt, wobei die der Erkennungsschaltung nachgeschaltete Unterteilungsschaltung (12) den zeitlichen Abstand zwischen dem Auftreten von zwei Erkennungssignalen in Teilbereiche zerlegt und die an die Unterteilungsschaltung (12) angeschlossene Torschaltung (13) in einem vorbestimmten derartigen Teilbereich aktiviert, und daß die Signalfolge des Sensors (1) der Komparatorschaltung (8) zugeführt ist, welche bei Überschreitung eines vorbestimmten Signalpegels einen elektrischen Impuls an die Torschaltung (13) abgibt, über die dieser in ihrem aktivierten Zustand der weiteren Verwendung zuführbar ist.

2. Einrichtung nach Anspruch 1, dadurch gekennzeichnet, daß die Torschaltung (13) in zumindest einem zweiten, gegenüber dem ersten längeren, Teilbereich, zwischen dem Auftreten von zwei Erkennungssignalen zusätzlich aktiviert ist und daß zwischen Sensor (1) und Komparatorschaltung (8) ein elektronisches Filter (5) mit veränderbarer Zeitkonstante eingeschaltet ist, welches im Teilbereich der zusätzlichen Aktivierung der Torschaltung (13) eine gegenüber dem ersten, kürzeren Teilbereich erhöhte Zeitkonstante aufweist.

3. Einrichtung nach Anspruch 2, dadurch gekennzeichnet, daß die Zeitkonstante des elektronischen Filters (5) zumindest im zusätzlichen, längeren Teilbereich in Abhängigkeit von der Auftrittsfrequenz des periodischen Ereignisses veränderbar ist.

**Claims**

1. A device for the generation of an electric pulse corresponding to the occurrence in time of an at least approximately periodic event, comprising one or more sensors (1) responding to the occurence of said event, which will feed a sequence of electric signals to an evaluation unit in turn comprising a recognition circuit (4) for delivering, upon arrival of the signal sequence, a stable recognition signal uncontaminated by noise whose occurrence will trigger a gate circuit (13), the output leads of which will furnish the pulse corresponding to the occurrence of said periodic event, wherein said evaluation unit is additionally provided with a partitioning circuit (12) and a comparator circuit (8), the partitioning circuit following the recognition circuit being intended for partitioning into subintervals the time interval between the occurrence of two recognition signals and for activating said gate circuit (13) during one of these subintervals which has been predetermined, and wherein the sequence of signals from said sensor (1) is fed to said comparator (8) which will transmit an electric pulse to said gate circuit (13) each time a predetermined signal level has been exceeded, which pulse will be available for further processing upon activation of said gate.

2. A device as in claim 1, wherein said gate circuit (13) is additionally activated during at least one other subinterval of the time elapsing between two recognition signals, which is larger than the first of said subintervals, and wherein an electronic filter (5) with variable time constant is incorporated between said sensor (1) and said comparator circuit (13) is increased as compared to the given during the first, shorter subinterval.

3. A device as in claim 2, wherein the time constant of said electronic filter (5) can be modified in accordance with the frequency of occurrence of said periodic event, at least during the additional, greater subinterval.

**Revendications**

1. Installation pour la génération d'une impulsion électrique correspondant à l'apparition d'un évènement au moins approximativement périodique, avec au moins un capteur (1) répondant à l'apparition de l'évènement et délivrante une suite de signaux électriques à une unité d'exploitation, laquelle comprend un montage de reconnaissance (4) qui, après arrivée de la suite de signaux, délivre un signal de reconnaissance stable, non influencé par parasites, en dépendance duquel se produit l'activation d'un circuit de porte (13) dont la sortie fournit l'impulsion affectée à l'apparition de l'évènement, installation caractérisée en ce que l'unité d'exploitation comprend, en outre, un circuit de subdivision (12) et un circuit de comparaison (8), le circuit de subdivision monté à la suite du circuit de reconnaissance, partageant l'intervalle de temps entre l'apparition de deux signaux de reconnaissance, en domaines partiels et activant le circuit de porte (13) relié au circuit de subdivision (12) dans un de ses domaines partiels prédéterminés, la suite de signaux du capteur (1) étant appliquée au circuit de comparaison (8), lequel, dans le cas d'un dépassement d'un seuil de signal prédéterminé, délivre une impulsion électrique au circuit de porte (13), lequel, dans son état activé, transmet cette impulsion vers une autre utilisation.

2. Installation suivant la revendication 1, caractérisée en ce que le circuit de porte (13) est activé, en plus, dans au moins un second domaine partiel, plus long que le premier, entre l'apparition de deux signaux de reconnaissance et entre le capteur (1) et le circuit de comparaison (8), est intercalé un filtre électronique (5) à constante de temps variable, lequel présente, dans le domaine partiel de l'activation supplémentaire du circuit de porte (13) une constante de temps plus grande que celle du premier domaine partiel.

3. Installation suivant la revendication 2, caractérisée en ce que la constante de temps du filtre électronique (5), est modifiable au moins dans le domaine partiel supplémentaire, plus long, en fonction de la fréquence d'apparition de l'évènement périodique.